# FASCICULE DE BREVET EUROPEEN

(11) **EP 3 200 663 B1**
(45) Date de publication et mention de la délivrance du brevet: **23.05.2018**
(21) Numéro de dépôt: 15787253.2
(22) Date de dépôt: 28.09.2015
(51) Int. Cl.: A47J 36/06, A47J 37/10, A47J 45/06

(54) **POIGNEE POUR RÉCIPIENT DE CUISSON COMPRENANT UN DISSIPATEUR THERMIQUE A CHALEUR LATENTE**
GRIFF FÜR EINEN KOCHBEHÄLTER MIT EINEM LATENTEN KÜHLKÖRPER
HANDLE FOR A COOKING VESSEL, COMPRISING A LATENT HEAT SINK

(30) Priorité: 30.09.2014 FR 1459230
(43) Date de publication de la demande: 09.08.2017
(73) Titulaire: SEB S.A., 69130 Ecully (FR)
(72) Inventeur: COMPEAU, Jean-Louis, 38070 Saint Quentin Fallavier (FR)
(74) Mandataire: Bourrières, Patrice
(86) Numéro de dépôt international: PCT/FR2015/052577
(87) Numéro de publication internationale: WO 2016/051058

(56) Documents cités:
- EP-A1- 2 361 538
- DE-A1-102012 202 196
- US-A1- 2002 040 711
- US-A1- 2008 290 104
- US-B1- 6 279 568

## Description

L'invention se situe dans le domaine des poignées pour des récipients de cuisson (appelés également récipients) ou pour des couvercles de récipients de cuisson, appelés simplement couvercles. L'invention concerne plus particulièrement des poignées intégrant des dispositifs de fourniture d'électricité dans le but d'alimenter des fonctions électroniques et qui fonctionnent sur le principe de la conversion thermoélectrique.

On connait déjà des récipients de cuisson comme par exemple des poêles à frire qui utilisent un dispositif de fourniture d'électricité tel qu'un générateur thermoélectrique pour alimenter un système électronique d'indication de température situé dans la poignée. Lorsque les poêles à frire sont chauffées un flux thermique se crée. Le générateur thermoélectrique utilise ce flux thermique pour produire de l'électricité nécessaire au fonctionnement du système électronique d'indication.

Le document CN201015533 divulgue une poêle électronique qui comprend un corps de poêle ainsi qu'une poignée qui est vissée à ce corps de poêle. La poêle comprend également un capteur de température et cette température peut être affichée sur un afficheur intégré dans la poignée. Afin d'alimenter ce capteur et cet afficheur la poêle comprend un générateur thermoélectrique qui génère de l'électricité pour le fonctionnement du capteur et de l'afficheur. Pour produire de l'électricité, ce générateur thermoélectrique comprend deux faces dont la première est positionnée contre le corps de la poêle. Ce positionnement permet d'assurer un échange thermique entre le générateur thermoélectrique et le corps de la poêle. Ce document divulgue également un dissipateur thermique relié à la seconde face du générateur thermoélectrique. Le dissipateur thermique est destiné à favoriser le refroidissement du générateur thermoélectrique et il a la forme d'un radiateur métallique comprenant des ailettes qui s'élèvent verticalement et parallèlement afin de créer un courant d'air de refroidissement par convection par un échange d'air suffisant avec l'air ambiant. Le document EP2361538 divulgue également une poignée pour un récipient de cuisson comprenant un générateur thermoélectrique, ledit générateur thermoélectrique comportant une première surface de contact reliée thermiquement à un dissipateur thermique.

Cependant pour qu'un tel radiateur soit efficace il faut dimensionner les ailettes de telle sorte que celles-ci aient un encombrement important dans la poignée. Il est alors difficile d'envisager de pouvoir mettre d'autres dispositifs dans cette poignée tel que par exemple le système électronique. Un autre inconvénient rencontré est que le fonctionnement de ce radiateur peut être perturbé voire empêché en fonction du mode d'usage de l'appareil en raison de la circulation de l'air ambiant au voisinage de ce radiateur.

L'un des aspects que se propose de résoudre la présente invention est de proposer un dissipateur thermique pour une poignée de récipient de cuisson ou de couvercle qui s'affranchisse du refroidissement par convection afin de rendre ce dissipateur thermique plus efficace et moins encombrant pour la poignée.

Ce but est atteint à l'aide d'une poignée pour récipient de cuisson ou couvercle selon la revendication 1. Selon une caractéristique de l'invention, le dissipateur thermique est composé d'un matériau solide dont la fusion s'effectue entre 50°C et 70°C.

Selon une caractéristique de l'invention, ce matériau solide est un mélange à base de paraffine solide.

Selon une caractéristique de l'invention, la poignée comprend un diffuseur thermique.

Selon une caractéristique de l'invention, le diffuseur thermique comprend une ou plusieurs tiges métalliques.

Selon une caractéristique de l'invention, la poignée comprend une pièce de jonction positionnée entre le générateur thermoélectrique et le diffuseur thermique.

Selon une caractéristique de l'invention, le diffuseur thermique est accroché à la pièce de jonction.

Selon une caractéristique de l'invention, la poignée comprend un dispositif électronique relié au générateur thermoélectrique.

Selon une caractéristique de l'invention, le dispositif électronique peut être un afficheur électronique ou un capteur électronique.

On comprendra mieux les buts, aspects et avantages de la présente invention, d'après la description donnée ci-après d'un mode particulier de réalisation de l'invention présenté à titre d'exemple non limitatif, en se référant aux dessins annexés dans lesquels :
- la figure 1 est une vue en coupe d'un récipient de cuisson comprenant une poignée conforme à l'invention ;
- la figure 2 est une vue de dessus d'un récipient de cuisson comprenant une poignée conforme à l'invention.

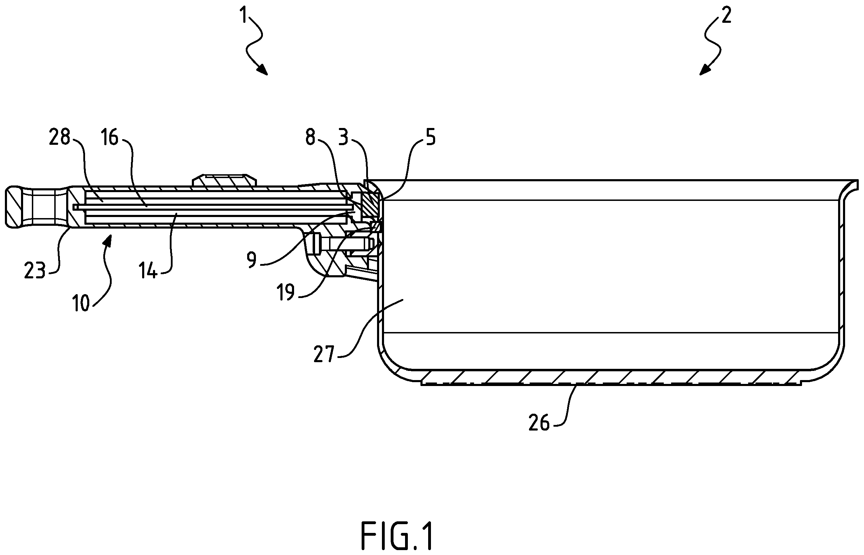

La poignée (1) pour récipient (2) de cuisson ou couvercle telle qu'illustrée sur la figure 1 est positionnée de façon fixe à un récipient (2) de cuisson ci après dénommé simplement récipient (2).

La fixation de la poignée (1) sur le récipient (2) ou le couvercle est effectuée de manière classique, soit par un système mécanique de vis-écrou, soit par un système de rivets.

Dans le cas d'un récipient (2), celui-ci comprend un fond (26), une paroi (27) qui entoure le fond (26) et une poignée (1). Ce récipient (2) peut être par exemple une poêle à frire mais peut également être une casserole, un faitout ou tout autre contenant métallique destiné à être chauffé thermiquement au niveau du fond (26). Le récipient (2) peut être fait en aluminium ou tout autre matériau conducteur de chaleur.

La poignée (1) comprend un corps principal (23). De façon non limitative celui-ci est fait dans un matériau thermostable. Ce corps (23) peut être fait dans tout autre matériau non conducteur de chaleur.

Le corps principal (23) est évidé en son centre et dans la longueur de la poignée (1) afin d'obtenir une cavité (28).

La poignée (1) comprend un générateur (3) thermoélectrique. Celui-ci est constitué d'au moins un module thermoélectrique qui peut être un module Peltier. Dans ce cas de figure il présente deux surfaces (5, 8) de contact. Une première (5) surface de contact, dite chaude, est mise en contact avec une source de chaleur alors que la seconde (8) surface de contact, dite froide, est quant à elle mise en contact avec une source froide.

Lorsque la poignée est fixée au récipient (2), la première (5) surface de contact du générateur (3) thermoélectrique vient en contact avec la paroi (27) du récipient (2).

Toujours en lien avec la figure 1, la poignée (1) comprend également une pièce (9) de jonction. La seconde (8) surface de contact du générateur (3) thermoélectrique est reliée thermiquement à cette pièce (9) de jonction.

La poignée (1) comprend également un dissipateur (10) thermique. Ce dissipateur (10) thermique est contenu dans la cavité (28) de la poignée (1).

Selon deux variantes, ce dissipateur (10) thermique peut être soit relié à la pièce (9) de jonction, soit relié directement à la seconde (8) surface de contact du générateur (3) thermoélectrique. Dans les deux cas le contact a une résistance thermique minimale.

Dans le second cas, cela signifie que la pièce (9) de jonction a été retirée.

Ce dissipateur (10) thermique est constitué d'un matériau pour lequel une transition de phase s'opère lorsque le matériau est amené à des températures allant de 50°C à 70°C.

Dans le mode de réalisation du dissipateur (10) thermique conforme à l'invention et visible à la figure 1, celui-ci est composé d'un matériau solide (14) dont la fusion s'effectue entre 50°C et 70°C.

Dans une réalisation particulière du matériau solide (14), celui-ci est un mélange à base de paraffine solide.

La poignée (1) peut comprendre en plus un diffuseur (16) thermique. Le diffuseur (16) thermique s'étend longitudinalement dans la poignée (1) et plus particulièrement dans le dissipateur (10) thermique.

Selon une caractéristique de l'invention, le diffuseur (16) thermique comprend une ou plusieurs tiges métalliques qui sont soit reliées à la pièce (9) de jonction, soit reliées directement à la seconde (8) surface de contact du générateur (3) thermoélectrique. Dans les deux cas le contact a une résistance thermique minimale.

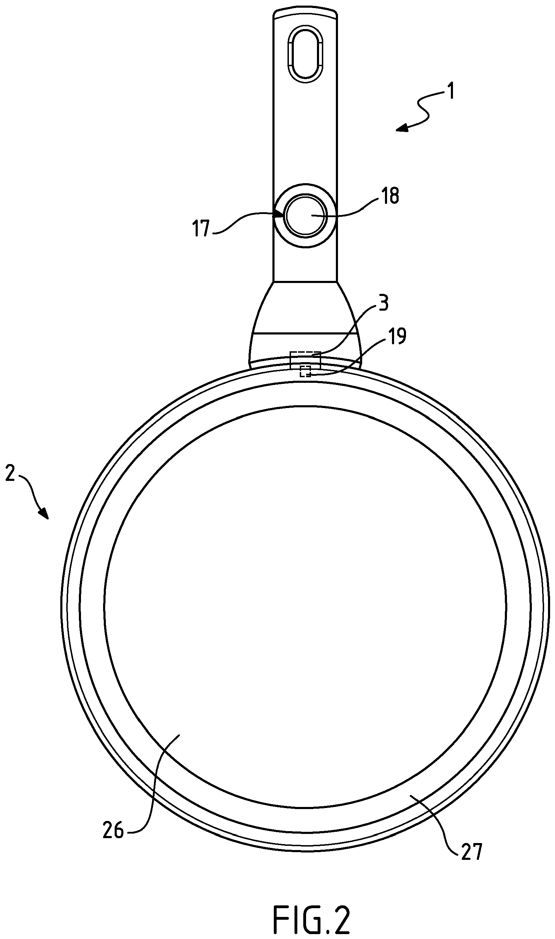

La poignée (1) peut également comprendre un dispositif électronique (17), comme visible à la figure 2, et relié au générateur (3) thermoélectrique. Ce dispositif électronique (17) peut être un afficheur (18) électronique ou un capteur électronique (19).

Ce capteur électronique (19) peut être par exemple et de façon non limitative un capteur de température.

Dans le cas d'un couvercle de récipient, la construction est la même qu'avec l'ustensile (2).

Lors de la mise en chauffe du récipient (2), celui-ci va progressivement s'échauffer. La paroi (27) contre laquelle est en contact la première (5) surface de contact du générateur (3) thermoélectrique s'élève également en température.

Cette paroi va constituer la source chaude pour le générateur (3) thermoélectrique.

Dans le cas où le dissipateur (10) thermique est constitué par un matériau solide dont le point de fusion est compris entre 50°C et 70°C, c'est ce matériau solide (14) qui est utilisé comme source froide du générateur (3) thermoélectrique et plus particulièrement l'énergie latente de changement de phase de ce matériau solide (14) qui est stocké dans la cavité (28) à proximité du générateur (3) thermoélectrique. Ce matériau solide (14), type paraffine solide, devra à son tour céder cette énergie latente à l'environnement lors d'une période de non utilisation du produit, ce qui ne pose pas de problème vu les cycles d'usage des produits domestiques.

Lors de la chauffe du récipient (2), un flux s'établit au travers du générateur (3) thermoélectrique, allant de la source chaude (la paroi (27) du récipient (2)) vers la source froide constituée du matériau solide (14) et éventuellement du diffuseur (16) thermique. Dans un premier temps, la température du matériau solide (14) va progressivement s'élever de la température ambiante jusqu'à sa température de fusion (environ 50°C). Ensuite, le matériau solide (14) va progressivement fondre, en restant à une température d'environ 50°C, permettant ainsi au flux thermique au travers du générateur (3) thermoélectrique de rester constant, et il en va de même pour la production électrique. Pendant cette période, la température de la poignée (1) reste relativement froide par rapport à une poignée classique. Au bout d'un temps qui dépend de la quantité de matériau solide (14) et de la puissance de la source de chaleur, le corps solide (14) sera complètement fondu, et la température de la poignée (1) recommencera à s'élever jusqu'à trouver un équilibre thermique avec la température ambiante.

Dans ce cas, les diffuseurs (16) thermiques ont pour but de faciliter le transfert thermique de la source chaude vers la source froide mais également de diffuser de manière optimale la chaleur dans l'ensemble du matériau solide (14).

On peut également avoir une telle construction mais sans diffuseurs (16) thermiques.

Dans un cas standard où le récipient (2) est placé sur un foyer dissipant 300W, une poignée (1) contenant 40 cm3 de matériau solide (14) type paraffine permet un fonctionnement stable du générateur (3) thermoélectrique pendant 85 minutes, la puissance maximale récupérable étant de 20mW sous 2,5V, alors que la température extérieure proche de la poignée (1) reste à 66°C.

On comprendra que diverses modifications et/ou améliorations évidentes pour l'homme du métier peuvent être apportées au mode de réalisation de l'invention décrit dans la présente description sans sortir du cadre de l'invention défini par les revendications annexées.

## Revendications

1. Poignée (1) pour récipient (2) de cuisson ou couvercle qui comprend au moins un générateur (3) thermoélectrique comprenant au moins une première (5) surface de contact reliée thermiquement à un dissipateur (10) thermique, **caractérisé en ce que** le dissipateur (10) thermique est constitué d'un matériau pour lequel une transition de phase s'opère lorsque le matériau est amené à des températures allant de 50°C à 70°C.

2. Poignée (1) pour récipient (2) de cuisson ou couvercle selon la revendication précédente **caractérisée en ce que** le matériau constituant le dissipateur (10) thermique est un matériau solide dont la fusion s'effectue entre 50°C et 70°C.

3. Poignée (1) pour récipient (2) de cuisson ou couvercle selon la revendication précédente **caractérisée en ce que** le matériau solide est un mélange à base de paraffine solide.

4. Poignée (1) pour récipient (2) de cuisson ou couvercle selon les revendications 2 à 3 **caractérisée en ce que** la poignée (1) comprend un diffuseur (16) thermique.

5. Poignée (1) pour récipient (2) de cuisson ou couvercle selon la revendication précédente **caractérisée en ce que** le diffuseur (16) thermique comprend une ou plusieurs tiges métalliques.

6. Poignée (1) pour récipient (2) de cuisson ou couvercle selon les revendications 4 à 5 **caractérisée en ce que** la poignée (1) comprend une pièce (9) de jonction positionnée entre le générateur (3) thermoélectrique et le diffuseur (16) thermique.

7. Poignée (1) pour récipient (2) de cuisson ou couvercle selon la revendication précédente **caractérisé en ce que** le diffuseur (16) thermique est accroché à la pièce (9) de jonction.

8. Poignée (1) pour récipient (2) de cuisson ou couvercle selon l'une des revendications précédentes **caractérisée en ce que** la poignée (1) comprend un dispositif électronique (17) relié au générateur (3) thermoélectrique.

9. Poignée (1) pour récipient (2) de cuisson ou couvercle selon la revendication précédente **caractérisée en ce que** le dispositif électronique (17) peut être un afficheur (18) électronique ou un capteur électronique (19).

## Patentansprüche

1. Griff (1) für ein Kochgefäß (2) oder eine Abdeckung, der mindestens einen thermoelektrischen Generator (3) umfasst, der mindestens eine erste Kontaktfläche (5) umfasst, die mit einem thermischen Dissipator (10) verbunden ist, **dadurch gekennzeichnet, dass** der thermische Dissipator (10) aus einem Material besteht, für das ein Phasenübergang auftritt, wenn das Material auf Temperaturen gebracht wird, die von 50 °C bis 70 °C gehen.

2. Griff (1) für ein Kochgefäß (2) oder eine Abdeckung nach dem vorhergehenden Anspruch, **dadurch gekennzeichnet, dass** das Material, das den thermischen Dissipator (10) bildet, ein festes Material ist, dessen Schmelzen zwischen 50 °C und 70 °C stattfindet.

3. Griff (1) für ein Kochgefäß (2) oder eine Abdeckung nach dem vorhergehenden Anspruch, **dadurch gekennzeichnet, dass** das feste Material eine Mischung auf Basis von festem Paraffin ist.

4. Griff (1) für ein Kochgefäß (2) oder eine Abdeckung nach den Ansprüchen 2 bis 3, **dadurch gekennzeichnet, dass** der Griff (1) einen thermischen Diffusor (16) umfasst.

5. Griff (1) für ein Kochgefäß (2) oder eine Abdeckung nach dem vorhergehenden Anspruch, **dadurch gekennzeichnet, dass** der thermische Diffusor (16) einen oder mehrere Metallstäbe umfasst.

6. Griff (1) für ein Kochgefäß (2) oder eine Abdeckung nach den Ansprüchen 4 bis 5, **dadurch gekennzeichnet, dass** der Griff (1) ein Verbindungsteil (9) umfasst, das zwischen dem thermoelektrischen Generator (3) und dem thermischen Diffusor (16) positioniert ist.

7. Griff (1) für ein Kochgefäß (2) oder eine Abdeckung nach dem vorhergehenden Anspruch, **dadurch gekennzeichnet, dass** der thermische Diffusor (16) an dem Verbindungsteil (9) befestigt ist.

8. Griff (1) für ein Kochgefäß (2) oder eine Abdeckung nach einem der vorhergehenden Ansprüche, **dadurch gekennzeichnet, dass** der Griff (1) eine elektronische Vorrichtung (17) umfasst, die mit dem thermoelektrischen Generator (3) verbunden ist.

9. Griff (1) für ein Kochgefäß (2) oder eine Abdeckung nach dem vorhergehenden Anspruch, **dadurch gekennzeichnet, dass** die elektronische Vorrichtung (17) eine elektronische Anzeige (18) oder ein elektronischer Sensor (19) sein kann.

## Claims

1. A handle (1) for a cooking vessel (2) or lid that comprises at least one thermoelectric generator (3) comprising at least one first contact surface (5) connected thermally to a heat sink (10), **characterized in that** the heat sink (10) is comprised of a material that undergoes a phase transition when the material is heated to temperatures of 50° C to 70° C.

2. The handle (1) for a cooking vessel (2) or lid according to the preceding claim, **characterized in that** the material of which the heat sink (10) is comprised is a solid material that melts between 50° C and 70° C.

3. The handle (1) for a cooking vessel (2) or lid according to the preceding claim, **characterized in that** the solid material is a solid paraffin-based mixture.

4. The handle (1) for a cooking vessel (2) or lid according to claims 2-3, **characterized in that** the handle (1) comprises a heat diffuser (16).

5. The handle (1) for a cooking vessel (2) or lid according to the preceding claim, **characterized in that** the heat diffuser (16) comprises one or more metal rods.

6. The handle (1) for a cooking vessel (2) or lid according to claims 4-5, **characterized in that** the handle (1) comprises a connection part (9) positioned between the thermoelectric generator (3) and the heat diffuser (16).

7. The handle (1) for a cooking vessel (2) or lid according to the preceding claim, **characterized in that** the heat diffuser (16) is attached to the connection part (9).

8. The handle (1) for a cooking vessel (2) or lid according to one of the preceding claims, **characterized in that** the handle (1) comprises an electronic device (17) connected to the thermoelectric generator (3).

9. The handle (1) for a cooking vessel (2) or lid according to the preceding claim, **characterized in that** the electronic device (17) may be an electronic display (18) or an electronic sensor (19).
